# EUROPÄISCHE PATENTSCHRIFT

(11) **EP 0 962 125 B1**
(45) Veröffentlichungstag und Bekanntmachung des Hinweises auf die Patenterteilung: **28.04.2004**
(21) Anmeldenummer: 98914794.7
(22) Anmeldetag: 20.02.1998
(51) Int. Cl.: H05K 13/04

(54) **VORRICHTUNG ZUM HERSTELLEN VON ELEKTRISCHEN BAUGRUPPEN**
DEVICE FOR PRODUCING ELECTRICAL COMPONENTS
DISPOSITIF PERMETTANT DE FABRIQUER DES COMPOSANTS ELECTRIQUES

(30) Priorität: 24.02.1997 DE 19707267; 24.02.1997 DE 19707266; 24.02.1997 DE 19707265
(43) Veröffentlichungstag der Anmeldung: 08.12.1999
(73) Patentinhaber: SIEMENS AKTIENGESELLSCHAFT, 80333 München (DE)
(72) Erfinder: GOLLER, Hugo, D-80797 München (DE); MELF, Johann, D-82541 Münsing (DE)
(86) Internationale Anmeldenummer: PCT/DE1998/000514
(87) Internationale Veröffentlichungsnummer: WO 1998/037744

(56) Entgegenhaltungen:
- EP-A- 0 315 799
- GB-A- 2 173 426
- US-A- 5 203 061

## Beschreibung

Die Erfindung bezieht sich auf eine Vorrichtung zum Herstellen von elektrischen Baugruppen, insbesondere zum Bestücken von Leiterplatten mit elektrischen Bauelementen, wobei die Vorrichtung ein Chassis mit zwei zueinander im wesentlichen parallelen linearen Längsführungen für zumindest zwei darauf verfahrbare z.B. balkenartige Wagen aufweist, die mit jeweils einem Querträger versehen sind, der eine zur Längsführung querstehende Querführung für zumindest einen darauf verfahrbaren Bearbeitungskopf für die Baugruppe aufweist.

Eine derartige Vorrichtung ist z.B. durch die US 5,002,448 bekannt geworden. Danach sind die beiden balkenartigen Wagen an zwei zueinander parallelen Führungsschienen des Chassis geführt, wobei jeder Wagen auf einem Ende ein Doppellager aufweist, das der genauen Längsführung und der Einhaltung der Winkellage des Wagens gegenüber der Führungsschiene dient. Ein einfaches Lager auf der jeweils gegenüberliegenden Seite dient der Abstützung des Querträgers an dieser Führungsschiene.

Das Einfachlager weist hier zwar auch Führungseigenschaften auf, die jedoch zu einer Überbestimmung des Lagersystems führen und dem Grunde nach nicht erforderlich sind. Die Lager sind hier einander derart zugeordnet, daß jeweils auf einer Seite ein Doppellager des ersten Wagens und auf der gegenüberliegenden Seite das Einfachlager des anderen Wagens angeordnet ist. Jedem der Doppellager ist eine Antriebseinheit zugeordnet, die den Wagen in der Richtung der Längsführung antreibt. Die beiden Querträger sind mit Querführungen versehen, auf denen jeweils ein Dreifach-Bestückkopf verfahrbar ist, der zwischen einer Bauelementezuführung und einem Bearbeitungsplatz des Chassis für die Baugruppe verfahrbar ist, um von den Bauteilezuführungen abgeholte Bauelemente bis zu deren Bestückplatz auf der Leiterplatte zu transportieren.

Geht man davon aus, daß das Einfachlager (wie z.B. nach der US 4,836,111) keine Führungs-, sondern lediglich eine Stützfunktion haben sollte, so kann definiert werden, daß jeder Wagen auf einer Seite an einer Längsführung geführt ist. Somit ragen die beiden Wagen von ihren Längsführungen aus zu den gegenüberliegenden Längsführungen, also in zueinander entgegengesetzter Richtung.

Ein Bestückplatz für eine Baugruppe befindet sich zwischen den beiden Längsführungen, wobei die Baugruppe während des Bestückens stationär fixiert ist. Die beiden Wagen sind in ihrer Funktion derart aufeinander abgestimmt, daß sie jeweils wechselweise die Bauteile auf die Leiterplatte aufsetzen bzw. von den Bauteilezuführungen abholen.

Beispielsweise durch das EP 0 315 799 ist ein Bestückautomat für Leiterplatten bekannt geworden, bei dem der Bestückkopf als Revolverkopf zur gleichzeitigen Aufnahme von z.B. 12 Bauelementen ausgebildet ist. Es ist üblich, ähnlich wie nach der erwähnten US 5,002,448, zwei Längsführungen für zwei ein ander entgegengesetzt gerichtete Wagen mit je einem Revolverkopf vorzusehen. Dabei kommt es häufig vor, daß der Abholzyklus kürzer ist als der Bestückzyklus. Der jeweils neu beladene Bestückkopf muß dann solange in einer Warteposition verweilen, bis der andere geleert ist, wodurch die Bestückleistung beeinträchtigt wird.

Durch die GB-A-2 173 426 ist ferner eine Bestückvorrichtung mit zwei zueinander parallelen stationären Querführungen für je einen Bestückkopf bekannt. Zwei simultan zu bestückende. Leiterplatten sind auf einem in zwei Koordinatenrichtungen verschiebbaren X-Y-Tisch im Abstand der Bestückköpfe fixiert. Die Bauelemente sind zu beiden Seiten des Tisches in längsverschiebbar gelagerten Zuführmodulen bereitgestellt. Der Bestückkopf weist zwei Greifer für die Bauelemente auf und ist auf der Querführung zwischen zwei Stationen linear so verfahrbar, daß die Bauelemente von den Zuführmodulen bis zur Mittelachse des X-Y-Tisches transportiert werden können, wo sie durch die X-Y-Verschiebung des Tisches an der vergesehenen Stelle auf die Leiterplatte aufgesetzt werden können. Der Abstand zwischen den beiden Greifern ist gleich dem Abstand zwischen der Mittelachse und den Abholstellen der Bauelemente, so daß gleichzeitig ein Bauelement abgeholt und ein anderes aufgesetzt werden kann. Ein derartiges Bestücksystem eignet sich besonders für bedrahtete Bauelemente, die mit ihren Anschlußbeinchen in entsprechende Löcher der Leiterplatte eingesetzt werden, sodaß sie beim Beschleunigen des Tisches nicht verrutschen können. Durch die Simultanbestückung sind beiden Bestückköpfen das jeweils gleiche Bauteilespektrum zugeordnet.

In der modernen Elektronik werden weit überwiegend SMD-Bauelemente verwendet, die mit ihren Anschlußbeinchen flach auf entsprechende Lötflecken auf der Leiterplatte aufgesetzt werden, was die Handhabung erheblich vereinfacht. Mit dem erwähnten Revolverkopf können z.B. 10 Bauelemente pro Sekunde aufgesetzt werden. Um zu verhindern, daß dabei die Bauelemente auf der Leiterplatte verrutschen, ist es üblich, die Leiterplatte beim Bestücken zu fixieren und den Bestückkopf zu verfahren. Der verschiebbare Tisch nach der GB-A-2 173 426 ist für solche Anforderungen nicht geeignet. Die Verfahrbarkeit des Bestückkopfes dient hier nicht der Positionierung in einer der Koordinatenrichtungen, sondern lediglich dem Transport der Bauelemente von der Abholstation in die Bestückstation, ähnlich wie es bei einer Bestückvorrichtung mit einem feststehenden Revolverkopf üblich ist. Die Bestückköpfe und die Querführungen sind daher hinsichtlich in ihrer Funktion nicht mit dem Bestückkopf und den Längsührungen nach der genannten US 5,002,448 zu vergleichen.

Der Erfindung liegt die Aufgabe zugrunde, die Bestückleistung der Vorrichtung zu erhöhen und den Herstellungsaufwand für die Vorrichtung zu verringern sowie die Zugänglichkeit zur Vorrichtung zu erleichtern.

Diese Aufgabe wird durch die Erfindung gemäß dem Anspruch 1 gelöst.

Die Bearbeitungsköpfe nach Anspruch 1 können derart unterschiedlich ausgebildet sein, daß sie sich nicht nur zum Be- . stücken, sondern auch zum Bügellöten, Messen, Prüfen oder Testen der Leiterplatte bzw. Baugruppe eignen. Andere Bearbeitungsköpfe können z.B. zum Auftragen von Flußmittel, Kleber oder Lotpaste vorgesehen sein.

Durch die zentrale Anordnung der Führungsschienen und die voneinander weg weisenden Querträger der z.B. balkenartigen Wagen ist es bei vergleichbarem Vorrichtungsaufwand möglich, gleichzeitig zwei Baugruppen unabhängig voneinander zu bearbeiten, ohne daß sich die Bearbeitungsköpfe gegenseitig behindern können. Die beiden Bestückplätzen ermöglichen annähernd eine Verdoppelung der Aufstellflächen für die Zuführmodule. Aufgrund der unabhängig arbeitenden Bearbeitungsköpfe können beiden Bestückplätzen unterschiedliche Bauelementespektren zugeordnet sein, wodurch die Vielfalt der Bauelementetypen erhöhen läßt. Ein weiterer Vorteil besteht darin, daß für beide Bearbeitungsplätze nur eine gemeinsame Steuereinrichtung benötigt wird.

Dadurch ist es möglich, die Bearbeitungskapazität der Maschine erheblich zu steigern. Durch die zentrale Anordnung der Längsführungen wird die Zugänglichkeit zu der Maschine von den Außenseiten her erheblich verbessert, es ist dann möglich, die Bauteilezuführungen auch an den Außenseiten der Maschine anzuordnen, die sich parallel zu den Längsführungen erstrecken. Ferner können durch die Zentralisierung der Längsführungen auch die Zuleitungen zu den Antrieben in der Mitte zusammengefaßt werden. Die Träger für die beiden Längsführungen können konstruktiv derart miteinander verbunden. werden, daß sie sich gegenseitig verstärken.

Durch die Erfindung nach Anspruch 5 ist es möglich, die Bearbeitungsleistung der Maschine noch weiter zu steigern, indem z.B. die als Bestückköpfe ausgebildeten Bearbeitungsköpfe abwechselnd Bauelemente abholen und auf die Leiterplatte aufsetzen. Die gemeinsame Führung für beide Wagen ist erheblich weniger aufwendig herzustellen und zu montieren als zwei getrennte Führungen für jeweils einen der Wagen. Indem die beiden Wagen an einer Längsführung geführt sind ist die den freien Enden des Querträgers zugeordnete Außenseite der Bearbeitungsvorrichtung besser zugänglich oder kann für periphere Zusatzeinrichtungen genutzt werden.

Dabei ist es z.B. auch möglich, den beiden Längsführungen eine unterschiedliche Anzahl von Wagen zuzuordnen. Ferner können die Bearbeitungsköpfe unterschiedliche Funktionen ausüben. Auf diese Weise läßt sich für unterschiedliche Bearbeitungsaufgaben eine jeweils optimale Konfiguration an Bearbeitungsköpfen bilden.

Vorteilhafte Weiterbildungen der Erfindungen sind in den Unteransprüchen gekennzeichnet:

Durch den gemeinsamen Längsträger nach Anspruch 2 ergibt sich ein stabiler und kompakter Aufbau der tragenden Konstruktion, so daß das Chassis kostengünstig gestaltet werden kann. Es ergibt sich ferner ein günstiger Massenschwerpunkt in der Mitte, wodurch sich auch das Schwingungsverhalten verbessert und die Standfestigkeit des Chassis erhöht.

Durch die Antriebseinheiten nach Anspruch 3 können die Antriebseinheiten und die Führungsmittel für die Wagen kompakt zusammengefaßt werden, was eine gewichtsparende und stabile Ausbildung ermöglicht.

Durch die Anordnung des z.B. linearen Baugruppentransports nach Anspruch 4 können die Leiterplatten in einer Transportlinie zu beiden Bearbeitungsplätzen geführt werden.

Die Weiterbildungen nach den Ansprüchen 6 und 7 ermöglicht es, den Querträger an seinem freien Ende freiragend auszubilden, so daß dort keine Führungs- oder Stützbahnen erforderlich sind. Damit wird die Zugänglichkeit zum Arbeitsbereich der Maschine weiter verbessert. Es ist nun auch möglich, auf der den freien Enden zugeordneten Außenseiten der Vorrichtung periphere Einrichtungen wie zusätzliche Bauelementemagazine oder andere Hilfseinrichtung anzuordnen.

Die senkrecht übereinanderliegenden Stütz- und Führungsbahnen nach Anspruch 8 benötigen eine geringere Baubreite als bei einer waagerechten Anordnung. Damit kann die Gesamtbreite der Maschine entsprechend verringert werden. Außerdem können sämtliche Stütz- und Führungsbahnen beider Längsführungen günstiger in einem Trägerteil von kompakter Bauweise zusammengefaßt werden.

Durch die Linearmotoren nach Anspruch 9 wird der Einsatz von mehreren Wagen an einer Längsführung erleichtert da die Linearmotoren keine zusätzlichen. Antriebsmittel wie Spindeln oder Zahnriemen benötigen. Ein derartiger Linearmotor besteht aus einem stationären Teil, z.B. einer Magnetschiene, die sich über die gesamte Länge der Langsführung erstreckt. Dem Wagen ist ein elektromagnetisch aktiver Teil zugeordnet, der mit der Magnetschiene in enger Wirkverbindung steht und der derart ansteuerbar ist, daß der Wagen exakt in eine vorbestimmte Position verfahren werden kann.

Durch die Anordnung des Linearmotors nach Anspruch 10, werden die Führungs und Antriebsmittel des Wagens zu einer kompakten und raumsparenden Anordnung zusammengefaßt.

Nach Anspruch 11 wirken die Führungselemente der Längsführung und die Teile des Linearmotors besonders vorteilhatt zusammen. Die magnetischen Kräfte des Linearmotors werden dafür genutzt, die Stütz- und Führungselemente des Wagens spielfrei und definiert gegen die Stütz- und Führungsbahnen der Längsführung zu ziehen, so daß die Querführung des Wagens in einer genauen Winkel- und Höhenlage gehalten wird und daß auf hintergreifende Führungsmittel verzichtet werden kann. Die Längsführung benötigt somit nur eine z.B. schienenartige Führungsbahn und die dazu parallel verlaufende Stützbahn zur genauen Längsführung und zur Einhaltung der Winkelposition des Querträgers gegenüber dem Chassis. Die permanenten Anziehungskräfte der Magnetschiene sind so groß, daß die der Wagen selbst nach dem Abschalten des Linearmotors sicher an der Längsführung gehalten wird.

Durch die Weiterbildung nach Anspruch 12 wird für die mobilen Teile der Linearmotoren nur ein einziger stationärer Teil benötigt. Dieser ist z.B. als einfache Magnetschiene ausgebildet und in den Längsträger raumsparend eingebettet.

Im folgenden wird die Erfindung anhand eines in der Zeichnung dargestellten Ausführungsbeispiels naher erlautert.
- Figur 1: zeigt eine Seitenansicht einer Vorrichtung zum Bestücken von Leiterplatten,
- Figur 2: eine Draufsicht auf die Vorrichtung nach Figur 1.

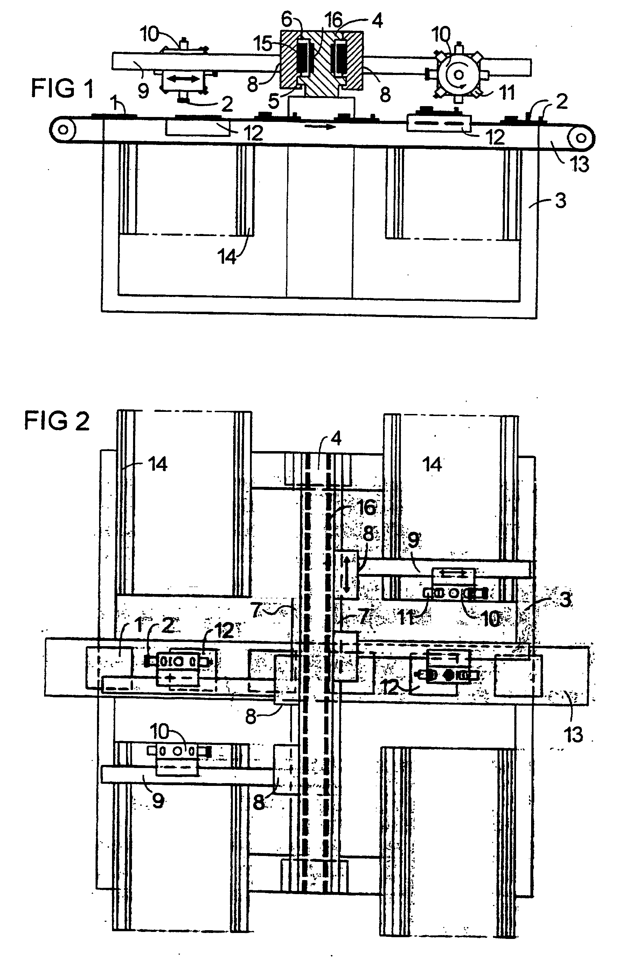

Nach den Figuren 1 und 2 weist eine Vorrichtung zum Bestücken von Leiterplatten 1 mit elektrischen Bauelementen 2 ein Chassis 3 mit einem Längsträger 4 auf, wobei die Leiterplatten 1 und die Bauelemente 2 zu einer Baugruppe 1, 2 zusammengesetzt werden. An dem Längsträger 4 sind sich waagerecht erstreckende Führungsbahnen 5 und Stützbahnen 6 senkrecht übereinanderliegend derart angeordnet, daß sie zusammen eine senkrechte Führungsebene einer linearen Längsführung 7 für zumindest einen entsprechend in dieser Richtung waagerecht verrahrbare Wagen 8 bilden, der einen sich senkrecht zu den Führungsbahnen 7 in waagerechter Richtung erstreckenden Quertrager 9 aufweist.

Dieser ist mit einer nicht näher dargestellten Querführung für einen als Bestückkopf ausgebildeten Bearbeitungskopf 10 versehen, der z.B. als Revolverkopf ausgebildet ist und der eine Vielzahl von sternförmig verteilten Saugpipetten 11 zum Greifen der Bauelemente 2 aufweist. Im mittleren Arbeitsbereich des Bearbeitungskopfes 10 ist ein Bearbeitungsplatz 12 des Chassis 3 angeordnet, der als Hubtisch ausgebildet ist und die zu bearbeitende Leiterplatte 1 auf eine Bearbeitungshöhe anhebt.

Ein linearer Baugruppentransport 13 erstreckt sich senkrecht zur Längsführung 7 über die gesamte Breite des Chassis 3. Zu beiden Seiten des Baugruppentransportes 13 sind Bauelementezuführungen 14 angeordnet, von denen der Bearbeitungskopf 10 Bauelemente 2 nach Bedarf abholt und auf die zu bestückende Leiterplatte 1 auf dem Hubtisch 12 aufsetzt.

Der Längsträger 4 ist beidseitig mit den Längsführungen 7 versehen, in denen auch auf der dem ersten Wagen 8 gegenüberliegenden Seite zumindest ein weiterer Wagen 8 geführt ist Die beiden Wagen 8 ragen von den zentralen Längsführungen 7 aus nach außen in entgegengesetzte Richtungen. Entsprechend ist auf dieser Seite ein weiterer Bearbeitungsplatz 12 zum Bestücken der Leiterplatten 1 mit den Bauelementen 2 vorgesehen, wobei der Baugruppentransport 13 über beide Bearbeitungsplätze geführt ist. Auf diese Weise ist es möglich, z.B. an zwei Bearbeitungsplätzen gleichzeitig mit zwei Bearbeitungsköpfen 10 zu arbeiten und die Bestückleistung entsprechend zu erhöhen.

Die Anordnung hat weiterhin den Vorteil, daß die Anzahl, der Bauelementezuführungen verdoppelt werden kann, so daß ein erheblich größeres Bauelementespektrum zur Verarbeitung an einer Maschine hereitgestellt werden kann. An jeder der Längsführungen 7 sind hier zwei Wagen 8 mit den Bearbeitungsköpfen 10 vorgesehen, wodurch sich die Bestückkapazität der Vorrichtung noch weiter erhöht. Die beiden Bestückköpfe sind dann so gesteuert, daß sie abwechselnd bestücken bzw. Bauelemente 1 von den Bauelementezuführungen 14 abholen.

Eine Antriebseinheit zum Verfahren des Wagens 4 ist hier als Linearmotor 15, 16 ausgebildet, der sich aus einem elektromagnetisch aktiven mobilen Teil 15 und einer stationären Magnetschiene 16 zusammensetzt, die sich über die gesamte Länge der Längsführung 7 erstreckt und in den zentralen Längsträger 4 eingelassen ist. Die Führungs- und Stützbahnen 5 und 6 sind raumsparend übereinanderliegend angeordnet. Der Linearmotor 15, 16 weist einen entsprechend senkrecht stehende magnetischen Trennspalt zwischen dem mobilen Teil 15 und der Magnetschiene 16 auf. Die wechselseitigen Berührungsflächen der Längsführung und der Trennspalt des Linearmotors bilden eine durchgehende gemeinsame Trennfuge. Dies bewirkt, daß Führungs- und Stützelemente des Wagens 4 durch die magnetische Anziehungskraft der Teile des Linearmotors 15 + 16 spielfrei gegen die Eührungs- und Stützbahnen 5 und 6 der Längsführung 7 gezogen werden.

Diese Kräfte sind so hoch, daß das andere Ende des Wagens, also das freie Ende des Querträgers 9 nicht abgestützt werden muß und somit freiragend ausgehildet werden kann. Auf dieser Seite sind somit keine Stützbahnen erforderlich, wodurch sich die Zugänglichkeit zum Arbeitsbereich der Maschine verbessert. Die permanenten Magnetkräfte des Linearmotors halten den Wagen selbst nach dem Abschalten in seiner waagerechten Position.

Sämtliche Wagen sind hier baugleich ausgebildet und auf beiden Seiten drehsymmetrisch angeordnet. Die den einzelnen Wagen 8 zugeordneten Linearmotoren sind so ausgebildet, daß sie die Magnetschiene 16 gemeinsam benutzen.

## Patentansprüche

1. Vorrichtung zum Herstellen von elektrischen Baugruppen (1, 2), insbesondere zum Bestücken von Leiterplatten (1) mit elektrischen Bauelementen (2),
wobei die Vorrichtung ein Chassis (3) mit zwei zueinander im wesentlichen parallelen linearen Längsführungen (7) für zumindest zwei darauf verfahrbare z.B. balkenartige Wagen (8) aufweist, die mit jeweils einem Querträger (9) versehen sind, der eine zur Längsführung (7) querstehende Querführung für zumindest einen darauf verfahrbaren Bearbeitungskopf (10) für die Leiterplatte aufweist,
wobei die Wagen (8) in einem Endbereich in den Längsführungen geführt sind und am anderen Ende ungeführt sind,
wobei die beiden Querträger (9) von der jeweiligen Längsführung (7) aus in einander entgegengesetzte Richtungen ragen und
wobei das Chassis zumindest einen Bearbeitungsplatz (12) aufweist, an dem die Baugruppe (1, 2) fixierbar ist,
**dadurch gekennzeichnet,**
**daß** die beiden Längsführungen (7) einander unmittelbar benachbart angeordnet sind,
**daß** die beiden Querträger (9) von ihren Längsführungen (7) aus jeweils in die der benachbarten Längsführung (7) abgewandte Richtung ragen und
**daß** zumindest zwei Bearbeitungsplätze (12) zu beiden Seiten der Längsführungen (7) vorgesehen sind.

2. Vorrichtung nach Anspruch 1,
**dadurch gekennzeichnet,**
**daß** die beiden Längsführungen (7) an einem gemeinsamen Längsträger (4) des Chassis (3) ausgebildet sind.

3. Vorrichtung nach Anspruch 1 oder 2,
**dadurch gekennzeichnet,**
**daß** zum Verfahren der Wagen (8) Antriebseinheiten vorgesehen, die den zugehörigen Längsführungen (7) zugeordnet sind.

4. Vorrichtung nach Anspruch 1, 2 oder 3,
**dadurch gekennzeichnet,**
**daß** ein Baugruppentransport (13) eine senkrecht zu den Längsführungen (7) orientierte Transportrichtung aufweist und beide Bearbeitungsplätze (12) bedient.

5. Vorrichtung nach einem der vorhergehenden Ansprüche,
**dadurch gekennzeichnet,**
**daß** an zumindest einer der Längsführungen (7) zumindest zwei voneinander unabhängig verfahrbare Wagen (8) geführt sind.

6. Vorrichtung nach einem der vorhergehenden Ansprüche,
**dadurch gekennzeichnet,**
**daß** die Längsführung (7) mit zumindest einer Stützbahn (6) und zumindest einer Führungsbahn (5) für entsprechende Stützund Führungselemente des Wagens versehen ist und
**daß** die Stütz- und Führungselemente an einem Ende des Wagens (8) angeordnet sind.

7. Vorrichtung nach Anspruch 6,
**dadurch gekennzeichnet,**
**daß** das andere Ende des Wagens (8) freiragend ausgebildet ist.

8. Vorrichtung nach Anspruch 6 oder 7,
**dadurch gekennzeichnet,**
**daß** die Stützbahn (6) und Führungsbahn (5) der Längsführung (7) im Querschnitt gesehen senkrecht übereinanderliegend angeordnet sind und eine entsprechend senkrecht orientierte Führungsebene bilden.

9. Vorrichtung nach Anspruch 6, 7 oder 8,
**dadurch gekennzeichnet,**
**daß** die Antriebseinheit des Wagens (8) als Linearmotor (15, 16) ausgebildet ist und der Längsführung (7) zugeordnet ist.

10. Vorrichtung nach Anspruch 9,
**dadurch gekennzeichnet,**
**daß** der Linearmotor (15, 16) zwischen der Stützbahn (6) und Führungsbahn (5) angeordnet ist.

11. Vorrichtung nach Anspruch 10,
**dadurch gekennzeichnet,**
**daß** ein Trennspalt zwischen einem mobilen Teil (15) und einem stationären Teil (16) des Linearmotors im Bereich der Stütz- und Führungsbahn (6 und 5) liegt und
**daß** der Trennspalt und die wechselseitigen Berührungsflächen zwischen den Führungselementen der Längsführung eine durchgehende gemeinsame Trennfuge bilden.

12. Vorrichtung nach Anspruch 9, 10 oder 11,
**dadurch gekennzeichnet,**
**daß** der durchgehende stationäre Teil (16) als gemeinsames stationäres Element für mehrere unabhängig betätigbare Linearmotoren der Wagen (8) vorgesehen ist und
**daß** der stationäre Teil (16) fest mit dem Längsträger (4) des Chassis (3) verbunden ist.

## Claims

1. Device for producing electric modules (1, 2), in particular for equipping printed circuit boards (1) with electric components (2),
wherein the device has a chassis (3) with two substantially mutually parallel linear longitudinal guides (7) for at least two carriages (8) that can be driven along them, such as girder-type carriages, each of which is equipped with a transverse carrier (9) having a transverse guide arranged at right angles to the longitudinal guide (7) for at least one processing head (10), which can be driven along it, for the printed circuit board,
wherein the carriages (8) are conducted at one end area along the longitudinal guides and at the other end are non-conducted, with the two transverse carriers (9) protruding from the respective longitudinal guide (7) in directions opposite to each other, and
with the chassis having at least one processing station (12) to which the module (1, 2) can be secured in position,
**characterized in that**
the two longitudinal guides (7) are arranged immediately adjacently,
**in that** the two transverse carriers (9) protrude from their longitudinal guides (7) in each case in the direction facing away from the adjacent longitudinal guide (7), and
**in that** at least two processing stations (12) are provided on both sides of the longitudinal guides (7).

2. Device according to Claim 1,
**characterized in that**
the two longitudinal guides (7) are embodied on a shared longitudinal carrier (4) of the chassis (3).

3. Device according to Claim 1 or 2,
**characterized in that**
drive units assigned to the associated longitudinal guides (7) are provided for driving the carriages (8).

4. Device according to Claim 1, 2 or 3,
**characterized in that**
a module transporter (13) has a transport direction oriented vertically to the longitudinal guides (7) and serves both processing stations (12).

5. Device according to one of the preceding Claims,
**characterized in that**
at least two mutually independently drivable carriages (8) are conducted along at least one of the longitudinal guides (7).

6. Device according to one of the preceding Claims,
**characterized in that**
the longitudinal guide (7) is provided with at least one support track (6) and at least one conducting track (5) for corresponding support and conducting elements of the carriage and
**in that** the support and conducting elements are arranged at one end of the carriage (8).

7. Device according to Claim 6,
**characterized in that**
the other end of the carriage (8) is embodied to be freely protruding.

8. Device according to Claim 6 or 7,
**characterized in that**
the support track (6) and conducting track (5) of the longitudinal guide (7) are, seen in cross-section, arranged vertically one above the other and form a correspondingly vertically oriented conducting level.

9. Device according to Claim 6, 7 or 8,
**characterized in that**
the drive unit of the carriage (8) is embodied as a linear motor (15, 16) and is assigned to the longitudinal guide (7).

10. Device according to Claim 9,
**characterized in that**
the linear motor (15, 16) is arranged between the support track (6) and conducting track (5).

11. Device according to Claim 10,
**characterized in that**
a separating gap between a mobile part (15) and a stationary part (16) of the linear motor is situated in the area of the support and conducting track (6 and 5), and
**in that** the separating gap and reciprocal contact surfaces between the conducting elements of the longitudinal guide form a continuous common partition.

12. Device according to Claim 9, 10 or 11,
**characterized in that**
the continuous stationary part (16) is provided as a common stationary element for plural independently actuatable linear motors of the carriages (8), and
**in that** the stationary part (16) is securely attached to the longitudinal carrier (4) of the chassis (3).

## Revendications

1. Dispositif de fabrication de modules électriques (1, 2), en particulier pour équiper en composants électriques (2) des cartes (1) de circuit imprimé,
le dispositif présentant un châssis (3) doté de deux guides longitudinaux linéaires (7), essentiellement parallèles l'un à l'autre, pour au moins deux chariots (8) configurés par exemple en forme de poutre, qui peuvent s'y déplacer et qui sont tous dotés d'un support transversal (9) qui présente un guide, transversal par rapport au guide longitudinal (7), pour au moins une tête de traitement (10), qui peut s'y déplacer, pour les cartes à circuit imprimé,
les chariots (8) étant guidés dans les guides longitudinaux dans une zone d'extrémité et n'étant pas guidés à l'autre extrémité,
les deux supports transversaux (9) débordant du guide longitudinal 7 respectif dans des directions mutuellement opposées et
le châssis présentant au moins un emplacement de traitement (12) sur lequel le module (1, 2) peut être immobilisé,
**caractérisé en ce**
**que** les deux guides longitudinaux (7) sont disposés à proximité directe l'un de l'autre,
**que** les deux supports transversaux (9) débordent de leur guide longitudinal (7) dans la direction non tournée vers le guide longitudinal (7) voisin et
**qu'**au moins deux emplacements de traitement (12) sont prévus des deux côtés des guides longitudinaux (7).

2. Dispositif selon la revendication 1,
**caractérisé en ce que**
les deux guides longitudinaux (7) sont réalisés sur un support longitudinal commun (4) du châssis (3).

3. Dispositif selon les revendications 1 ou 2,
**caractérisé en ce que**
des unités d'entraînement qui sont associées aux guides longitudinaux (7) associés sont prévues pour le déplacement des chariots (8).

4. Dispositif selon les revendications 1, 2 ou 3,
**caractérisé en ce**
**qu'**un transport (13) de modules présente une direction de transport orientée perpendiculairement aux guides longitudinaux (7) et dessert les deux emplacements de traitement (12).

5. Dispositif selon l'une des revendications précédentes,
**caractérisé en ce**
**qu'**au moins deux chariots (8) qui peuvent être déplacés indépendamment l'un de l'autre sont guidés sur au moins l'un des guides longitudinaux (7).

6. Dispositif selon l'une des revendications précédentes,
**caractérisé en ce que**
le guide longitudinal (7) est doté d'au moins une piste de soutien (6) et d'au moins une piste de guidage (5) pour des éléments correspondants de soutien et de guidage du chariot et **en ce que** les éléments de soutien et de guidage sont disposés à une extrémité du chariot (8).

7. Dispositif selon la revendication 6,
**caractérisé en ce que**
l'autre extrémité du chariot (8) est configurée en porte-à-faux.

8. Dispositif selon les revendications 6 ou 7,
**caractérisé en ce que**
la piste de soutien (6) et la piste de guidage (5) du guide longitudinal (7) sont disposées en coupe transversale en superposition verticale et forment un plan de guidage correspondant orienté à la verticale.

9. Dispositif selon les revendications 6, 7 ou 8,
**caractérisé en ce que**
l'unité d'entraînement du chariot (8) est configurée comme moteur linéaire (15, 16) et est associée au guide longitudinal (7).

10. Dispositif selon la revendication 9,
**caractérisé en ce que**
le moteur linéaire (15, 16) est disposé entre la piste de soutien (6) et la piste de guidage (5).

11. Dispositif selon la revendication 10,
**caractérisé en ce**
**qu'**un entrefer entre une partie mobile (15) et une partie stationnaire (16) du moteur linéaire est situé dans la région de piste de soutien et de guidage (6 et 5), et en ce que l'entrefer et les surfaces de contact mutuel entre les éléments de guidage du guide longitudinal forme un joint de séparation commun et continu.

12. Dispositif selon les revendications 9, 10 ou 11,
**caractérisé en ce que**
la partie stationnaire continue (16) est prévue comme élément stationnaire commun pour plusieurs moteurs linéaires, aptes à être actionnés indépendamment, des chariots (8) et **en ce que** la partie stationnaire (16) est reliée solidairement au support longitudinal (4) du châssis (3).
